(19) Europäisches Patentamt
European Patent Office
Office européen des brevets

(11) **EP 2 359 472 B1**

(12) **FASCICULE DE BREVET EUROPEEN**

(45) Date de publication et mention
de la délivrance du brevet:
**15.11.2017 Bulletin 2017/46**

(51) Int Cl.:
*H03F 1/02* (2006.01)      *H03F 1/32* (2006.01)
*H04L 27/36* (2006.01)

(21) Numéro de dépôt: **09804299.7**

(86) Numéro de dépôt international:
**PCT/FR2009/052580**

(22) Date de dépôt: **16.12.2009**

(87) Numéro de publication internationale:
**WO 2010/070231 (24.06.2010 Gazette 2010/25)**

(54) **DISPOSITIF ET PROCEDE DE TRAITEMENT D'UN SIGNAL, SYSTEME D'EMISSION RADIOFREQUENCE COMPORTANT UN TEL DISPOSITIF**

VORRICHTUNG UND VERFAHREN ZUR VERARBEITUNG EINES SIGNALS UND HOCHFREQUENZÜBERTRAGUNGSSYSTEM MIT EINER DERARTIGEN VORRICHTUNG

DEVICE AND METHOD FOR PROCESSING A SIGNAL, AND RADIOFREQUENCY TRANSMISSION SYSTEM COMPRISING SUCH A DEVICE

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **17.12.2008 FR 0858676**
**13.01.2009 FR 0950161**

(43) Date de publication de la demande:
**24.08.2011 Bulletin 2011/34**

(73) Titulaire: **Commissariat à l'Énergie Atomique et aux Énergies Alternatives**
**75015 Paris (FR)**

(72) Inventeur: **WURM, Patrick**
**Décédé (FR)**

(74) Mandataire: **Bonnet, Michel**
**Cabinet Bonnet**
**93, rue Réaumur - Boîte 10**
**75002 Paris (FR)**

(56) Documents cités:
• **MOHAMED HELAOUI ET AL: "A New Mode-Multiplexing LINC Architecture to Boost the Efficiency of WiMAX Up-Link Transmitters" IEEE TRANSACTIONS ON MICROWAVE THEORY AND TECHNIQUES, IEEE SERVICE CENTER, PISCATAWAY, NJ, US, vol. 34, no. 2, 1 février 2007 (2007-02-01), pages 248-253, XP011163684 ISSN: 0018-9480**
• **PATRICK WURM ET AL: "Radio transmitter architecture with all-digital modulator for opportunistic radio and modern wireless terminals" COGNITIVE RADIO AND ADVANCED SPECTRUM MANAGEMENT, 2008. COGART 2008. FIRST INTERNATIONAL WORKSHOP ON, IEEE, PISCATAWAY, NJ, USA, 14 février 2008 (2008-02-14), pages 1-4, XP031247477 ISBN: 978-1-4244-2139-8**
• **ZHANG X ET AL: "Calibration scheme for LINC transmitter" ELECTRONICS LETTERS, IEE STEVENAGE, GB, vol. 37, no. 5, 1 mars 2001 (2001-03-01), pages 317-318, XP006016330 ISSN: 0013-5194**
• **ANU HUTTUNEN ET AL: "A 20-W Chireix Outphasing Transmitter for WCDMA Base Stations" IEEE TRANSACTIONS ON MICROWAVE THEORY AND TECHNIQUES, IEEE SERVICE CENTER, PISCATAWAY, NJ, US, vol. 55, no. 12, 1 décembre 2007 (2007-12-01), pages 2709-2718, XP011197128 ISSN: 0018-9480**

**Description**

La présente invention concerne un dispositif de traitement d'un signal porteur d'une information destinée à être transmise à l'aide d'un signal radiofréquence. Elle concerne également un système d'émission radiofréquence comportant un tel dispositif et un procédé correspondant.

L'invention s'applique plus particulièrement à l'émission radiofréquence d'informations à l'aide de terminaux de communication sans fil tels que des téléphones portables par exemple, et plus précisément à l'aide de terminaux sans fil capables d'émettre dans une large gamme de puissances et selon plusieurs normes d'émission distinctes.

Chaque norme, par exemple GSM, EDGE, WCDMA, HSDPA, 3G, 4G, WIFI, WIMAX, 802.11, 802.16, etc., émet dans une bande de fréquences d'émission spécifique dans la bande de fréquences des ondes radioélectriques. En outre chaque norme émet selon une modulation particulière.

Ainsi, un émetteur radiofréquence adapté pour émettre selon une norme particulière n'est généralement pas adapté pour une émission selon une autre norme. Par exemple, l'architecture d'un émetteur radiofréquence selon la norme GSM est basée sur une modulation directe de type GMSK à amplitude constante et comporte donc généralement un modulateur analogique dont la sortie est connectée à un amplificateur de puissance. Au contraire, l'architecture d'un émetteur radiofréquence selon la norme EDGE est basée sur une modulation de type 8-PSK à amplitude non constante et est généralement à boucle polaire. Mais une architecture à boucle polaire est limitée en largeur de bande des signaux transmis et peut difficilement transmettre des signaux à largeur de bande supérieure à celle prévue par la norme EDGE. Par ailleurs, pour les transmissions à plus large bande, comme celles prévues par les normes 3G et 4G utilisant une modulation de type OFDM, une architecture à modulation directe et amplification linéaire est généralement privilégiée.

Aujourd'hui, pour gérer toutes ces normes et l'incompatibilité de leurs architectures respectives, des terminaux multinormes sont conçus sur la base de plusieurs dispositifs microélectroniques d'émission, chacun dédié à une norme en particulier. Cette solution de court terme, consistant à intégrer plusieurs dispositifs microélectroniques d'émission dans un même terminal multinormes, s'avère coûteuse et inefficace. Elle induit une duplication de fonctions d'émission radiofréquence dans un seul terminal qui devient alors encombrant.

Il existe donc un réel besoin d'un dispositif de traitement d'un signal porteur d'une information destinée à être transmise à l'aide d'un terminal d'émission de signaux radiofréquences qui permette de concevoir une architecture capable de couvrir une large bande de fréquences, de supporter une pluralité de types de modulations et de réagir instantanément à un grand nombre de requêtes d'utilisateur possibles.

En termes de performances, une telle architecture sera aussi jugée par sa capacité à fournir une puissance suffisante à consommation d'énergie la plus faible possible puisqu'elle est généralement destinée à être installée dans un terminal mobile, par sa capacité à permettre des émissions de données à haut débit et par un rapport signal sur bruit élevé.

Par exemple, l'architecture à boucle polaire est très performante en termes de consommation d'énergie puisqu'elle se satisfait d'une amplification modérément non linéaire présentant une bonne efficacité en gain de puissance.

Mais pour des transmissions à large bande, une architecture à amplification linéaire s'impose généralement. En effet, pour obtenir une plus grande efficacité spectrale, dans ce type de transmission les signaux sont modulés en phase et en amplitude selon la représentation polaire suivante: $s(t) = A(t).\exp(j.(\omega t + \theta(t)))$. Selon cette représentation polaire, l'expression $A(t)$ est l'amplitude, toujours positive, du signal, l'expression $\theta(t)$ est la phase et w la porteuse. Or, les signaux à amplitude variable imposent généralement d'utiliser des amplificateurs à réponse linéaire pour éviter les distorsions. Comme chaque amplificateur est limité en linéarité par ses caractéristiques AM/AM et AM/PM, cela implique de prévoir des amplificateurs qui fonctionnent linéairement dans une zone suffisamment éloignée de leur gain de saturation, et cela rend le système d'émission peu efficace parce que ces amplificateurs sont alors moins performants en termes de consommation d'énergie.

L'architecture connue sous le nom de LINC (de l'Anglais « LInear amplification using Nonlinear Components ») apporte une solution pour permettre une amplification linéaire de signaux à amplitude variable à l'aide d'amplificateurs fonctionnant en saturation de gain, c'est-à-dire à efficacité maximale pour des niveaux de puissance élevés. Cette architecture permet en outre de se passer de boucles de commande telles que des boucles polaires.

Cette architecture prévoit un dispositif de traitement en bande de base d'un signal $s(t) = A(t).\exp(j.\theta(t))$ porteur d'une information destinée à être transmise à l'aide d'un signal radiofréquence, pour la transformation de ce signal en deux signaux d'amplitudes $A_C$ identiques et constantes déphasés respectivement par rapport au signal porteur de l'information selon deux déphasages variables et opposés :

$$s_1(t) = A_C.\exp(j\varphi(t)).\exp(j.\theta(t)),$$

et

$$s_2(t) = A_C . \exp(-j\varphi(t)) . \exp(j.\theta(t)) .$$

Ainsi, en représentation vectorielle, le signal en bande de base $s(t)$ porteur de l'information est vu comme la somme de ces deux signaux d'amplitudes constantes $A_C$ dont les déphasages respectifs opposés $\varphi(t)$ et $-\varphi(t)$ sont fonction de l'amplitude variable du signal porteur de l'information.

Plus précisément :

$$A_C = \frac{\max[A(t)]}{2} ,$$

et

$$\varphi(t) = \cos^{-1}\left[\frac{A(t)}{2A_C}\right] .$$

Ces deux signaux à amplitude constante peuvent alors être modulés (facteur $\exp(j.\omega t)$) et amplifiés selon deux voies de modulation et d'amplification indépendantes avant d'être recombinés avant émission. L'amplification dans chacune des deux voies n'a pas besoin d'être linéaire puisque aucun de ces deux signaux ne porte d'information en amplitude. Les amplificateurs sollicités sont donc avantageusement utilisés dans leur zone de saturation pour améliorer l'efficacité globale du système d'émission radiofréquence.

En effet, soit $G = G_{SAT} . \exp(j0)$ la fonction de transfert commune des amplificateurs des deux voies de modulation et d'amplification, à saturation.

En sortie de la première voie de modulation et d'amplification, le premier des deux signaux à amplitude constante prend la forme suivante :

$$s_{O,1}(t) = G_{SAT} . s_1(t) = G_{SAT} . A_C . \exp(j.\varphi(t) + j.\omega t + j.\theta(t)) .$$

En sortie de la seconde voie de modulation et d'amplification, le second des deux signaux à amplitude constante prend la forme suivante :

$$s_{O,2}(t) = G_{SAT} . s_2(t) = G_{SAT} . A_C . \exp(-j.\varphi(t) + j.\omega t + j.\theta(t)) .$$

Par recombinaison de ces deux signaux modulés et amplifiés indépendamment, on obtient :

$$s_O(t) = s_{O,1}(t) + s_{O,2}(t) ,$$

soit

$$s_O(t) = G_{SAT} . A_C . \exp(j.\varphi(t) + j.\omega t + j.\theta(t)) + G_{SAT} . A_C . \exp(-j.\varphi(t) + j.\omega t + j.\theta(t)) ,$$

$$s_O(t) = [G_{SAT} . A(t)] . \exp(j.(\omega t + \theta(t))) ,$$

d'où

$$s_O(t) = G_{SAT} . s(t) .$$

L'amplification du signal $s(t)$ est donc effectivement linéaire, bien que ce signal soit d'amplitude variable et que les amplificateurs soient utilisés à saturation de gain.

En termes de puissance fournie par rapport à la puissance consommée, si l'on suppose que dans tous les cas un filtrage post-amplification à -3dB de pertes est nécessaire et réalisable, pour fournir par exemple un signal à +30dBm à l'antenne d'émission, une architecture à amplificateur unique doit fournir un signal à +33dBm en sortie de l'amplificateur unique, et à +27dBm en sortie de l'amplificateur unique pour fournir par exemple un signal à +24dBm. Pour que l'amplificateur fonctionne dans sa zone de linéarité, généralement avec une marge de 4dB par rapport à son gain de saturation, il doit donc être conçu pour supporter +37dBm en saturation si l'on veut être capable d'émettre un signal à +30dBm. En supposant une efficacité de 50 %, cela donne une consommation généralement comprise entre 5 et 10 W selon la classe de l'amplificateur. Une telle architecture présentant ce type de performance est par exemple décrite dans l'article de P. Wurm et A. Shirakawa, intitulé « Radio transmitter architecture with all-digital modulator for opportunistic radio and modern wireless terminals », CogART 2008, Proceedings on 2008 First International Workshop on Cognitive Radio and Advanced Spectrum Management, 14 février 2008.

A titre de comparaison, une architecture de type LINC à deux voies d'amplification doit fournir un signal à +27dBm (pour $\varphi = 0$) en sortie de chaque amplificateur pour fournir un signal à +30 dBm à l'antenne d'émission : en effet, dans cette architecture, le filtrage post-amplification à -3dB de pertes peut également remplir la fonction de module de recombinaison des deux signaux à amplitude constante. Pour $\varphi = 60°$ et pour un signal à +27dBm en sortie de chaque amplificateur, le signal fourni à l'antenne d'émission est à +24dBm. En supposant une efficacité de 50 %, cela donne une consommation de 2 W puisque l'architecture LINC fonctionne toujours à saturation.

L'architecture LINC est donc clairement avantageuse parce qu'elle permet d'échapper au conflit traditionnel entre linéarité et consommation d'énergie qui nécessite généralement de faire des compromis dans le choix et la conception des amplificateurs.

Bien sûr, cette architecture nécessite théoriquement que les deux voies de modulation et d'amplification fonctionnent de manière identique pour que la recombinaison des deux signaux à amplitude constante permette, en sortie de l'amplification, de retrouver parfaitement le signal porteur d'information modulé et amplifié au niveau de l'antenne du terminal d'émission radiofréquence.

En pratique, l'architecture LINC pose un premier problème parce que la transformation du signal porteur d'information d'amplitude variable en deux signaux d'amplitudes constantes n'est par nature pas linéaire. Cette transformation élargit le spectre du signal transmis ce qui pousse jusqu'à leurs limites les capacités du système d'émission radiofréquence en bande passante, notamment par exemple lorsqu'il s'agit d'applications à large bande telles que des applications WCDMA. Par conséquent, pour des applications multinormes, l'architecture LINC classique atteint rapidement ses limites.

En pratique également, l'architecture LINC est particulièrement sensible à tout décalage en gain ou en phase entre les deux voies de modulation et d'amplification. Or un tel décalage est inévitable, notamment dans la partie amplification de ces voies. On montre par exemple qu'un signal modulé en OFDM, recombiné après traitement sur deux voies de modulation et d'amplification présentant un décalage de 5 % en gain (i.e. 0,42dB) et de 3° en phase, peut présenter un spectre ne vérifiant pas les contraintes du masque spectral OFDM. Par conséquent, l'architecture LINC nécessite de prévoir une calibration très précise des deux voies de modulation et d'amplification.

Notamment, dans une plage de valeurs possibles, plus le signal porteur d'information est d'amplitude faible, plus les imprécisions de la calibration ont des conséquences sur sa recombinaison.

Par exemple, si le décalage en amplitude est nul entre les deux voies, c'est-à-dire si $|s_{O,1}(t)| = |s_{O,2}(t)| = G_{SAT} . A_C$ (en omettant le terme $\exp(j.(\omega t + \theta(t))))$ dans les équations, ce qui n'altère pas la validité des calculs qui portent sur les amplitudes de signaux), le signal $s_O(t)$ a pour amplitude :

- $|s_O(t)| = 2 . G_{SAT} . A_C$ pour $\varphi = 0$ ,
- $|s_O(t)| = G_{SAT} . A_C$ pour $\varphi = 60°$, et
- $|s_O(t)| = 0,2 . G_{SAT} . A_C$ pour $\varphi = 84,26°$ ,

soit une dynamique de 20dB entre 0 et 84,26°.

Si le décalage est de ± 5 % en amplitude entre les deux voies, c'est-à-dire si $|s_{O,1}(t)| = 1,05 . G_{SAT} . A_C$ et $|s_{O,1}(t)| = 0,95 . G_{SAT} . A_C$ par exemple, le signal $|s_O(t)|$ a pour amplitude :

- $|s_O(t)| = 2 . G_{SAT} . A_C$ pour $\varphi = 0$,
- $|s_O(t)| = 1,0037 . G_{SAT} . A_C$ pour $\varphi = 60°$, avec une phase égale à $\arg[s_O(t)] = 4,94°$, et
- $|s_O(t)| = 0,223 . G_{SAT} . A_C$ pour $\varphi = 84,26°$, avec une phase égale à $\arg[s_O(t)] = 26,4°$.

soit une dynamique de 19dB entre 0 et 84,26°.

Cet exemple montre, d'une part, que la dynamique est réduite de 1dB à cause du décalage de ± 5 % en amplitude entre les deux voies et, d'autre part, que les conséquences sur le signal recombiné sont plus importantes à faible amplitude. Ainsi, à amplitude maximale ($\varphi$ = 0) l'impact est nul, à la moitié de l'amplitude maximale ($\varphi$ = 60°) l'impact est limité, tandis qu'à faible amplitude, par exemple $\varphi$ = 84,26°, l'impact devient vraiment sensible.

Plus généralement, des signaux de dynamique importante seront affectés par un passage dans une architecture LINC présentant une calibration imparfaite. Le document "A New Mode-Multiplexing LINC Architecture to Boost the Efficiency of WiMAX Up-Link Transmitters", Helaoui et al, IEEE Transactions on Microwave Theory, vol. 55, no. 2, 2007, décrit un procédé de traitement d'un signal porteur d'une information destinée à être transmise à l'aide d'un signal radiofréquence, comportant une étape de transformation de ce signal en deux signaux d'amplitudes constantes déphasés respectivement par rapport au signal porteur de l'information selon deux déphasages variables et opposés tant que l'amplitude du signal porteur d'information est inférieure à une valeur prédéterminée (mode LINC), ou une étape de transformation de ce signal en deux signaux strictement identiques lorsque l'amplitude du signal porteur d'information est supérieure à la valeur prédéterminée. Il peut ainsi être souhaité de prévoir un dispositif de traitement d'un signal porteur d'une information destinée à être transmise à l'aide d'un signal radiofréquence, qui permette de s'affranchir des problèmes et contraintes précités.

L'invention a donc pour objet un dispositif de traitement d'un signal porteur d'une information destinée à être transmise à l'aide d'un signal radiofréquence, pour la transformation de ce signal en deux signaux d'amplitudes identiques déphasés respectivement par rapport au signal porteur de l'information selon deux déphasages variables et opposés, comportant des moyens de transformation du signal porteur d'information conçus pour :

-   transformer le signal porteur d'information en deux signaux d'amplitudes constantes et de déphasages variables en fonction des valeurs du signal porteur d'information, tant que l'amplitude du signal porteur d'information est supérieure à une valeur prédéterminée, et
-   transformer le signal porteur d'information en deux signaux d'amplitudes variables en fonction des valeurs du signal porteur d'information, lorsque l'amplitude du signal porteur d'information est inférieure à cette valeur prédéterminée.

Ainsi, un dispositif de traitement selon l'invention s'apparente à un dispositif d'architecture LINC tant que l'amplitude du signal porteur d'information est suffisamment élevée pour que le traitement de type LINC ne soit pas pénalisé par une calibration imparfaite, mais limite les déphasages opposés des deux signaux d'amplitudes identiques en jouant sur leurs amplitudes lorsque l'amplitude du signal porteur d'information n'est plus suffisamment élevée. Il comporte donc les avantages d'un dispositif de type LINC tout en limitant ses inconvénients.

De façon optionnelle, les moyens de transformation sont conçus pour transformer le signal porteur d'information en deux signaux de phases constantes fixées en valeur absolue à une valeur maximale et d'amplitudes variables en fonction des valeurs du signal porteur d'information, lorsque que l'amplitude du signal porteur d'information est inférieure à la valeur prédéterminée.

De façon optionnelle également, la valeur prédéterminée est définie en fonction d'une distribution de l'amplitude du signal porteur d'information.

L'invention a également pour objet un système d'émission de signaux radiofréquence comportant :

-   des moyens de production d'un signal complexe porteur d'information à moduler,
-   un dispositif de traitement tel que défini précédemment, pour la transformation de ce signal complexe en deux signaux d'amplitudes identiques,
-   des moyens de modulation des deux signaux d'amplitudes identiques comportant deux voies de modulation distinctes,
-   des moyens de recombinaison des deux signaux d'amplitudes identiques modulés pour la formation d'un signal radiofréquence à émettre, et
-   des moyens d'émission de ce signal radiofréquence.

De façon optionnelle, les moyens de production, le dispositif de traitement et les moyens de modulation sont numériques, chaque voie de modulation comportant au moins un modulateur numérique de type sigma delta.

De façon optionnelle également, les moyens de recombinaison sont analogiques, et le système comporte en outre :

-   des moyens de conversion numérique/analogique des deux signaux d'amplitudes identiques issus des moyens de modulation, pour la fourniture de deux signaux analogiques,
-   des moyens de filtrage passe bande des deux signaux analogiques dans une bande de fréquence d'émission prédéterminée, et
-   des moyens d'amplification des deux signaux analogiques filtrés pour la fourniture de deux signaux analogiques filtrés et amplifiés aux moyens de recombinaison.

De façon optionnelle également, un système selon l'invention peut comporter en outre un circuit interne de calibration conçu pour compenser un décalage en gain et en phase des moyens d'amplification des deux signaux analogiques filtrés.

De façon optionnelle également, un système selon l'invention peut comporter en outre un circuit interne de prédistorsion conçu pour compenser une non linéarité en gain et/ou en phase des moyens d'amplification des deux signaux analogiques filtrés.

De façon optionnelle également, le circuit interne de calibration et le circuit interne de prédistorsion sont formés par un même circuit comportant un dispositif de couplage positionné dans les moyens de recombinaison pour récupérer une portion de la puissance d'émission du signal radiofréquence et un amplificateur logarithmique pour transformer cette portion récupérée en une tension exploitable par le dispositif de traitement.

Enfin, l'invention a également pour objet un procédé de traitement d'un signal porteur d'une information destinée à être transmise à l'aide d'un signal radiofréquence, pour la transformation de ce signal en deux signaux d'amplitudes identiques déphasés respectivement par rapport au signal porteur de l'information selon deux déphasages variables et opposés, comportant les étapes suivantes :

- transformer le signal porteur d'information en deux signaux d'amplitudes constantes et de déphasages variables en fonction des valeurs du signal porteur d'information, tant que l'amplitude du signal porteur d'information est supérieure à une valeur prédéterminée, et
- transformer le signal porteur d'information en deux signaux d'amplitudes variables en fonction des valeurs du signal porteur d'information, lorsque l'amplitude du signal porteur d'information est inférieure à cette valeur prédéterminée.

L'invention sera mieux comprise à l'aide de la description qui va suivre, donnée uniquement à titre d'exemple et faite en se référant aux dessins annexés dans lesquels :

- la figure 1 représente schématiquement la structure générale d'un système d'émission de signaux radiofréquences selon l'invention,
- les figures 2A, 2B et 2C illustrent, à l'aide d'une représentation vectorielle, deux modes de réalisation d'un procédé de traitement de signal porteur d'une information destinée à être transmise par signal radiofréquence mis en oeuvre dans le système d'émission de la figure 1,
- les figures 3A et 3B illustrent, à l'aide d'une représentation vectorielle, le principe de fonctionnement d'une méthode de calibration mise en oeuvre dans le système d'émission de la figure 1,
- les figures 4A à 4F illustrent partiellement, à l'aide d'une représentation vectorielle, le principe de fonctionnement d'une première méthode de prédistorsion mise en oeuvre dans le système d'émission de la figure 1,
- les figures 5A et 5B illustrent partiellement, à l'aide d'une représentation vectorielle, le principe de fonctionnement d'une seconde méthode de prédistorsion mise en oeuvre dans le système d'émission de la figure 1,
- les figures 6A et 6B illustrent graphiquement les performances spectrales respectives de systèmes d'émission de l'état de la technique et selon l'invention, pour une émission de type OFDM,
- les figures 7A et 7B illustrent graphiquement les performances spectrales respectives de systèmes d'émission de l'état de la technique et selon l'invention, pour une émission de type WCDMA.

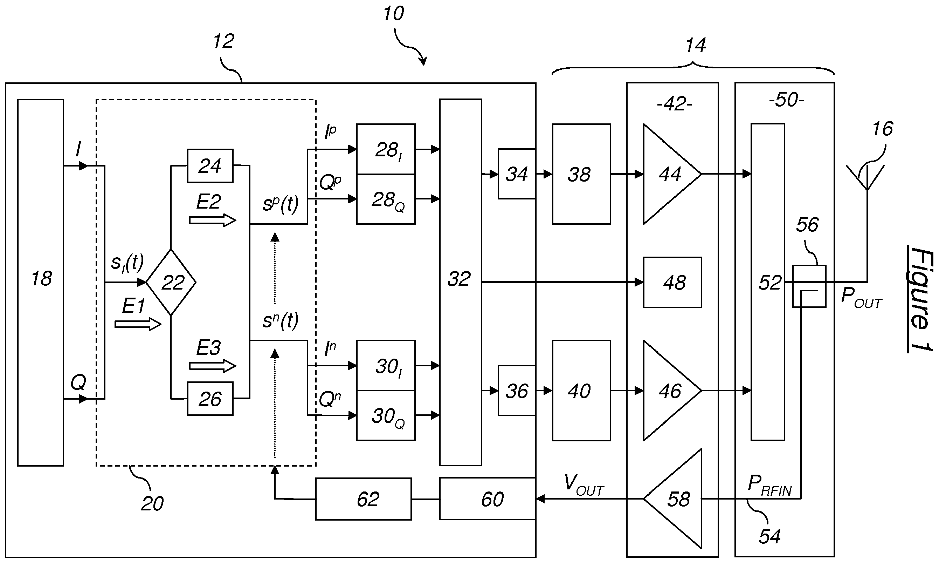

Le système 10 d'émission de signaux radiofréquences représenté sur la figure 1 comporte un générateur 12 de signaux radiofréquences, un étage 14 de filtrage et d'amplification des signaux radiofréquences produits par le générateur 12 et une antenne d'émission 16 pour l'émission par ondes radioélectriques des signaux radiofréquences amplifiés fournis par l'étage de filtrage et d'amplification 14.

Pour la mise en oeuvre de l'invention, le générateur 12 de signaux radiofréquences peut être au moins partiellement analogique, mais dans un mode de réalisation préféré, il est numérique : il est conçu sur la base d'un circuit microélectronique de type CMOS par exemple, capable de fonctionner aux radiofréquences.

En effet, les solutions analogiques traditionnelles sont très sensibles aux variations de température, de fréquence et de traitement alors qu'une solution numérique permet de générer des signaux plus prédictibles. En outre, les solutions analogiques font appel à des composants externes dont les paramètres sont difficiles à modifier. Au contraire, un circuit entièrement numérique à base de technologie CMOS présente un haut niveau de flexibilité parce qu'il est programmable et reconfigurable. Il permet donc d'envisager une architecture capable de couvrir une large bande de fréquences et de supporter une pluralité de types de modulations selon une pluralité de normes possibles, en permettant de générer des signaux radiofréquences de types très variés. Il supporte par exemple au moins les normes précitées GSM, EDGE, WCDMA, HSDPA, 3G, 4G, WIFI, WIMAX, 802.11, 802.16, etc.

Le générateur numérique 12 comporte ainsi un module multinormes 18 de production d'un signal numérique complexe porteur d'une information destinée à être transmise à l'aide d'un signal radiofréquence. Ce signal numérique complexe est produit en bande de base selon un format imposé par l'une quelconque des normes supportées par le générateur numérique 12 et peut s'écrire, en coordonnées cartésiennes ou polaires, de la façon suivante :

$$s_I(t) = I(t) + j.Q(t) = A_I(t).\exp(j.\theta(t)).$$

Les signaux numériques réels en quadrature I et Q sont produits à une fréquence d'échantillonnage prédéterminée et quantifiés sur N bits, par exemple concrètement sur six, huit ou dix bits.

Le cas échéant, le module de production multinormes 18 peut comporter un dispositif de filtrage numérique, par exemple de type RRC (de l'Anglais « Root Raised Cosine ») ou équivalent, pour limiter l'étalement spectral du signal numérique complexe produit à la largeur du canal de transmission envisagé.

Il peut en outre comporter un dispositif de sur-échantillonnage connecté au dispositif de filtrage numérique pour élever le signal numérique complexe produit en sortie du dispositif de filtrage numérique à une fréquence d'échantillonnage plus élevée que la fréquence d'échantillonnage prédéterminée, par interpolation et décimation.

Les dispositifs de filtrage numérique et de sur-échantillonnage précités ne sont pas représentés sur la figure 1 et ne seront pas détaillés dans la suite de la description étant donné qu'ils sont bien connus de l'état de la technique.

Selon un premier aspect de l'invention, le générateur numérique 12 comporte en outre un dispositif numérique 20 de traitement du signal numérique complexe porteur d'information $s_I(t)$, pour la transformation de ce signal en deux signaux $s^p(t)$ et $s^n(t)$ d'amplitudes identiques déphasés respectivement par rapport au signal porteur de l'information selon deux déphasages variables et opposés. D'une façon générale, ces deux signaux d'amplitudes identiques peuvent s'écrire, en coordonnées cartésiennes ou polaires, de la façon suivante :

$$s^p(t) = I^p(t) + j.Q^p(t) = A(t).\exp(j.\varphi(t) + j.\theta(t)),$$

et

$$s^n(t) = I^n(t) + j.Q^n(t) = A(t).\exp(-j.\varphi(t) + j.\theta(t)).$$

Plus précisément, le dispositif numérique de traitement 20 comporte des moyens 22 de comparaison de l'amplitude variable $A_I(t)$ du signal porteur d'information $s_I(t)$ avec une valeur prédéterminée $A_{MIN}$ constante, par exemple définie comme étant égale à la moitié de la valeur maximale que peut prendre cette amplitude $A_I(t)$. Pour plus de souplesse, cette valeur prédéterminée $A_{MIN}$ peut aussi être réglable. Notamment, elle peut être définie en fonction de la distribution de l'amplitude variable $A_I(t)$ du signal porteur d'information.

En sortie de ces moyens de comparaison 22, si l'amplitude du signal porteur d'information est supérieure à cette valeur prédéterminée $A_{MIN}$, celui-ci est traité par des premiers moyens 24 de transformation du signal porteur d'information en deux signaux d'amplitudes constantes et dont les déphasages sont variables en fonction des valeurs du signal porteur d'information. Ce premier traitement correspond à l'architecture LINC précédemment décrite.

Si, au contraire, l'amplitude du signal porteur d'information est inférieure à cette valeur prédéterminée $A_{MIN}$, celui-ci est traité par des seconds moyens 26 de transformation du signal porteur d'information en deux signaux d'amplitudes variables en fonction des valeurs du signal porteur d'information. Ceci permet de limiter les valeurs du déphasage $\varphi(t)$ et de jouer aussi sur les valeurs d'amplitudes des deux signaux d'amplitudes identiques lors de la transformation du signal porteur d'information. En effet, en sortie du dispositif numérique de traitement 20, les deux signaux d'amplitudes identiques sont destinés à suivre deux voies de modulation, filtrage et amplification distinctes avant d'être recombinés pour former un signal radiofréquence à émettre. La limitation des valeurs du déphasage $\varphi(t)$ permet de limiter l'impact d'un décalage en gain ou en phase de ces deux voies de traitement, comme cela a été vu précédemment.

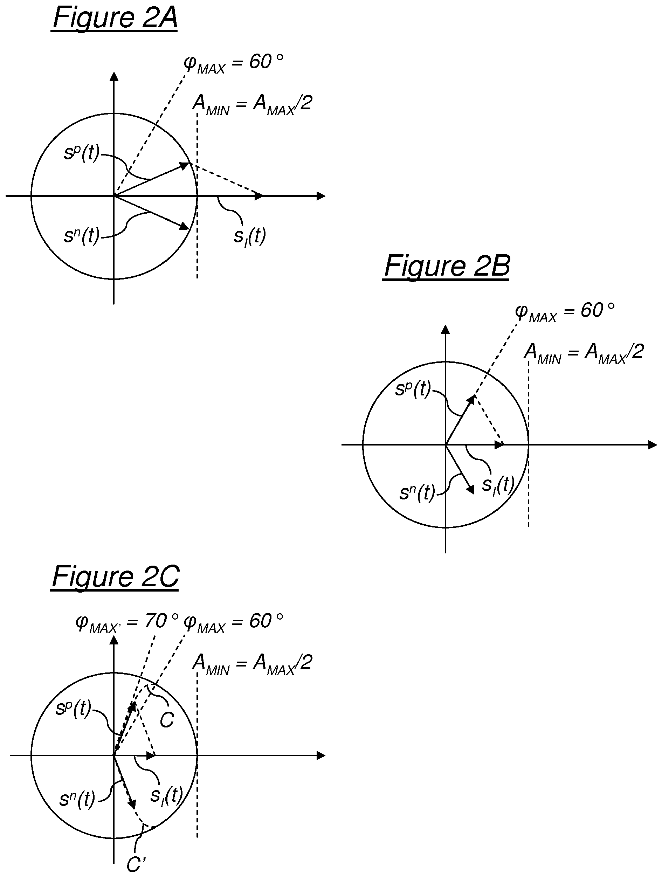

Les moyens 22, 24 et 26 sont représentés comme fonctionnellement séparés sur la figure 1 par souci de clarification mais peuvent tout à fait être mis en oeuvre dans un même circuit microélectronique programmé formant le dispositif numérique de traitement 20. Leur fonctionnement sera détaillé ultérieurement, en référence aux figures 2A à 2C.

Le générateur numérique 12 comporte, en sortie du dispositif numérique de traitement 20, des moyens $28_I$, $28_Q$, $30_I$, $30_Q$ de modulation des deux signaux $s^p(t)$ et $s^n(t)$ d'amplitudes identiques comportant deux voies de modulation distinctes et effectuant des traitement indépendants. Une première voie $28_I$, $28_Q$ traite les parties réelle et imaginaire $I^p$ et $Q^p$ du premier $s^p(t)$ des deux signaux. Une seconde voie $30_I$, $30_Q$ traite les parties réelle et imaginaire $I^n$ et $Q^n$ du second $s^n(t)$ des deux signaux.

Plus précisément, dans un mode de réalisation de l'invention, la première voie $28_I$, $28_Q$ comporte deux modulateurs sigma delta pour réaliser une modulation à la fréquence porteuse d'émission souhaitée des signaux $I^p$ et $Q^p$. L'un de ces deux modulateurs sigma delta, portant la référence $28_I$, traite spécifiquement le signal $I^p$. L'autre, portant

la référence $28_Q$, traite spécifiquement le signal $Q^p$. Ces deux modulateurs sigma delta sont à faible résolution de sortie parce que de hautes fréquences porteuses peuvent être atteintes au prix d'une baisse de la résolution des signaux modulés. Ainsi, à partir d'un signal quantifié sur N bits, un modulateur sigma delta tel que les modulateurs $28_I$ et $28_Q$ remplit une fonction de filtrage de type passe bas ou passe bande en produisant un signal de sortie quantifié sur M bits (par exemple trois niveaux +1, 0, -1 lorsque M = 1,5 bits), M étant inférieur à N.

De même, la seconde voie $30_I$, $30_Q$ comporte deux modulateurs sigma delta pour réaliser une modulation à la fréquence porteuse d'émission souhaitée des signaux $I^n$ et $Q^n$. L'un de ces deux modulateurs sigma delta, portant la référence $30_I$, traite spécifiquement le signal $I^n$. L'autre, portant la référence $30_Q$, traite spécifiquement le signal $Q^n$. Ces deux modulateurs sigma delta sont également à faible résolution et remplissent une fonction de filtrage de type passe bas ou passe bande en produisant des signaux de sortie quantifiés sur M bits.

Les paramètres des modulateurs sigma delta $28_I$, $28_Q$, $30_I$, $30_Q$ sont choisis en fonction de la norme choisie pour l'émission radiofréquence de sorte que le bruit de quantification qu'ils génèrent soit le plus possible rejeté en dehors de la bande de fréquences correspondant à la norme choisie pour que le rapport signal sur bruit des signaux quantifiés sur M bits soit le plus élevé possible dans cette bande de fréquences.

Les modulateurs sigma delta sont connus de l'homme du métier et ne seront pas davantage décrits. Pour plus de détails sur l'agencement et le fonctionnement de ces modulateurs, on pourra se reporter par exemple au document intitulé « An overview of sigma delta converters » de P.M. Aziz, H.V. Sorensen et J. Van Der Spiegel, IEEE Signal Processing Magazine, vol. 13, n°1, Janvier 1996.

Le générateur numérique 12 comporte, en sortie des modulateurs sigma delta $28_I$, $28_Q$, $30_I$, $30_Q$ des deux voies de modulation, un module supplémentaire 32 de traitement numérique de signal dont la fonction est d'optimiser le spectre des signaux numériques modulés et de préparer une conversion numérique/analogique. En effet, si le générateur 12 est numérique, l'étage 14 de filtrage et d'amplification des signaux radiofréquences produits par le générateur 12 reste, quant à lui, composé d'éléments analogiques.

A son interface avec l'étage de filtrage et d'amplification 14, le générateur numérique 12 comporte donc deux dispositifs de conversion numérique/analogique 34 et 36, un pour chaque voie de modulation $28_I$, $28_Q$ et $30_I$, $30_Q$. Ces deux dispositifs de conversion numérique/analogique fournissent deux signaux modulés analogiques d'amplitudes identiques $s_a^p(t)$ et $s_a^n(t)$.

Chaque dispositif de conversion numérique/analogique 34, 36 comprend par exemple un tampon de sortie, qui réalise la conversion des signaux numériques en impulsions de courant, ainsi qu'une source de courant commandée par ce tampon de sortie.

On notera ainsi que les dispositifs de conversion numérique/analogique 34, 36 sont très simples, capables de fonctionner à une fréquence très élevée comprise entre 5 et 10 GHz, et produisent des impulsions très courtes.

L'étage de filtrage et d'amplification 14 comporte deux dispositifs de filtrage passe bande analogiques 38 et 40, un pour chaque voie de modulation et pour chacun des deux signaux modulés analogiques d'amplitudes identiques, opérant dans une bande de fréquences d'émission prédéterminée. Dans un mode de réalisation préféré, ces deux dispositifs de filtrage passe bande 38 et 40 sont des filtres très sélectifs, notamment des filtres BAW-CRF (de l'Anglais « Bulk Acoustic Wave - Coupled Resonator Filter »). Ils atténuent fortement le spectre des signaux délivrés par le générateur numérique 12 en dehors de la bande de fréquences d'émission choisie, notamment pour éliminer avec une grande précision le bruit de quantification généré par les modulateurs sigma delta $28_I$, $28_Q$, $30_I$, $30_Q$. Pour plus de précisions sur ces filtres BAW-CRF et leur intérêt dans une telle architecture, notamment en combinaison avec les modulateurs sigma delta précités, on se reportera à l'article de P. Wurm et A. Shirakawa, intitulé « Radio transmitter architecture with all-digital modulator for opportunistic radio and modern wireless terminals », CogART 2008, Proceedings on 2008 First International Workshop on Cognitive Radio and Advanced Spectrum Management, 14 février 2008.

L'étage de filtrage et d'amplification 14 comporte en outre un module d'amplification 42 comportant deux voies distinctes d'amplification de puissance raccordées chacune à la source de courant du dispositif de conversion numérique/analogique correspondant.

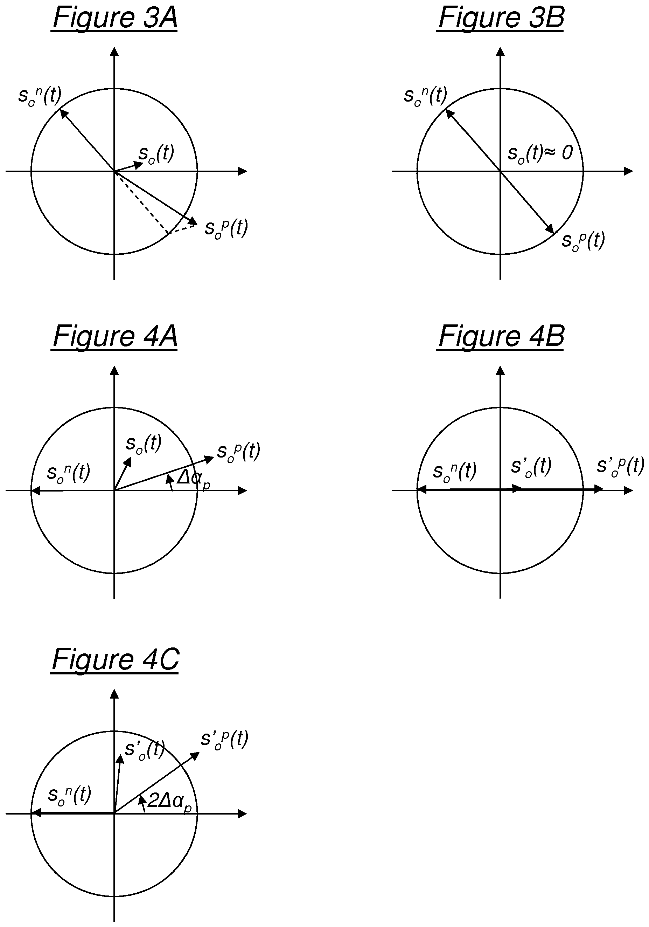

La première voie d'amplification, associée à la première voie de modulation, comprend un premier amplificateur 44, dont les caractéristiques de gain et de déphasage seront notées par la suite $G_p$ et $\alpha_p$, recevant le signal $s_a^p(t)$ en entrée et fournissant un signal $s_o^p(t)$ en sortie. La seconde voie d'amplification, associée à la seconde voie de modulation, comprend un second amplificateur 46, dont les caractéristiques de gain et de déphasage seront notées par la suite $G_n$ et $\alpha_n$, recevant le signal $s_a^n(t)$ en entrée et fournissant un signal $s_o^n(t)$ en sortie. Les différences inévitables entre les paramètres $G_p$ et $\alpha_p$, d'une part, et $G_n$ et $\alpha_n$, d'autre part, induisent un décalage en gain et en phase qu'il est possible de corriger par calibration pour une bonne recombinaison des signaux $s_o^p(t)$ et $s_o^n(t)$. Un mode de réalisation préféré de cette calibration sera détaillé en référence aux figures 3A et 3B.

Les amplificateurs 44 et 46 reçoivent des signaux qui ont été transformés, soit par les premiers moyens 24, soit par les seconds moyens 26.

Les signaux transformés par les premiers moyens 24 étant d'amplitudes identiques et constantes, les gains des amplificateurs 44 et 46 sont réglés par un dispositif 48 de commande de gain pour que les amplificateurs fonctionnent en mode saturé lorsqu'ils reçoivent ces signaux. Le dispositif 48 de commande de gain est intégré au module d'amplification 42 mais reçoit une consigne de gain du module supplémentaire 32 de traitement numérique de signal. Le module supplémentaire de traitement numérique 32 détermine la consigne de gain en fonction d'une puissance requise pour l'émission par l'antenne.

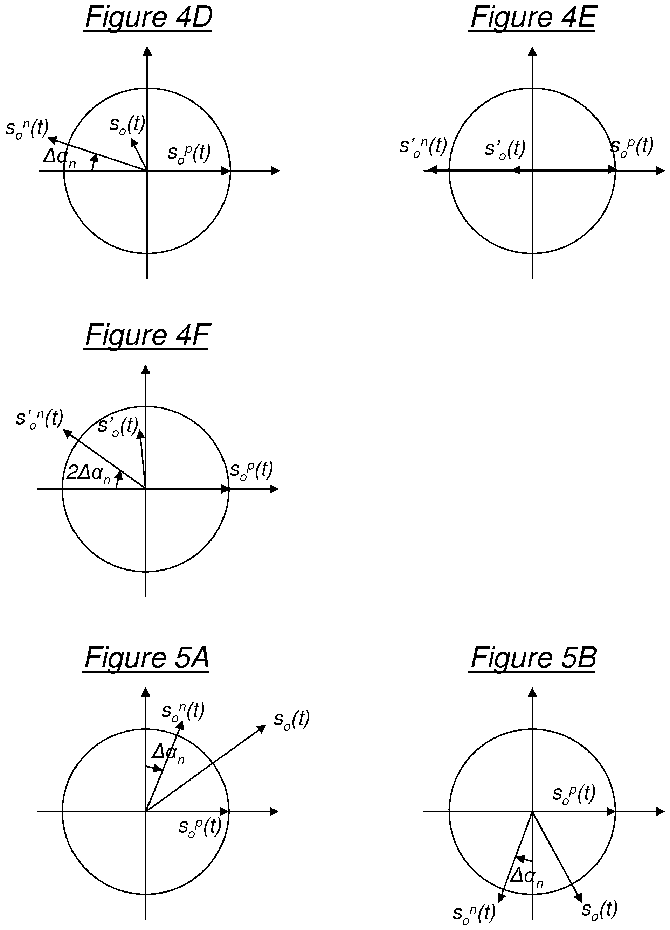

Les signaux transformés par les seconds moyens 26 étant d'amplitudes identiques mais variables et inférieures aux amplitudes constantes des signaux transformés par les premiers moyens 24, ils sont susceptibles de subir des distorsions liées aux caractéristiques AM/AM et AM/PM des amplificateurs 44 et 46. Il est possible de corriger ces distorsions par l'application d'une méthode de prédistorsion. Deux modes de réalisation préférés de méthodes de prédistorsion seront détaillés en références aux figures 4A, 4B et 5A, 5B.

Enfin, l'étage de filtrage et d'amplification 14 comporte un module de recombinaison 50 comportant des moyens 52 de post-filtrage et de recombinaison des deux signaux $s_o^p(t)$ et $s_o^n(t)$ issus des deux amplificateurs 44 et 46 pour la formation d'un signal radiofréquence, modulé en phase et en amplitude autour de la fréquence porteuse d'émission choisie, destiné à être émis par l'antenne 16.

Ces moyens de post-filtrage et de recombinaison 52 comportent par exemple des filtres de type BAW-CRF agencés de façon connue en soi pour réaliser cette recombinaison. Ces filtres permettent en outre avantageusement de bien maintenir les niveaux de puissance élevés souhaités, de compléter la réduction du bruit de quantification réalisée par les dispositifs de filtrage 38 et 40 et de réaliser une adaptation d'impédance avec l'antenne 16. En outre, dans les systèmes de type « full-duplex », ils permettent de bien séparer les canaux d'émission (TX) et de réception (RX).

Selon un second aspect de l'invention, le système 10 d'émission de signaux radiofréquences comporte en outre un circuit interne de calibration 54. Comme indiqué précédemment, les différences entre les paramètres $G_p$ et $\alpha_p$ de l'amplificateur 44, d'une part, et $G_n$ et $\alpha_n$ de l'amplificateur 46, d'autre part, induisent un décalage en gain et en phase qu'il est possible de corriger par calibration. Cette calibration en phase et en amplitude est nécessaire pour tous les systèmes à architecture LINC classiques. Elle est également souhaitable pour l'architecture présentée précédemment selon le premier aspect de l'invention. Elle est en général externe et réalisée une seule fois lors de la conception/fabrication du système d'émission radiofréquence.

Le fait qu'un circuit interne spécifique de calibration 54 soit prévu dans le système 10 d'émission de signaux radiofréquences permet de réaliser cette calibration à n'importe quel moment, de façon répétée et complètement transparente par le système 10.

Ce circuit de calibration 54 comporte un dispositif de couplage 56 positionné dans le module de recombinaison 50 sur l'alimentation de l'antenne 16 en sortie des moyens 52 de post-filtrage et de recombinaison. Il permet au circuit de calibration 54 de récupérer une portion $P_{RFIN}$ de la puissance d'émission $P_{OUT}$, proportionnelle à celle-ci. Si l'on note $A_{dB}$ l'atténuation en dB du signal dans le circuit de calibration 54, cette portion $P_{RFIN}$ est donnée par la relation suivante :

$$(P_{RFIN})_{dB} = (P_{OUT})_{dB} - A_{dB}.$$

Ce circuit de calibration 54 comporte aussi un amplificateur logarithmique 58 qui reçoit en entrée cette portion $P_{RFIN}$ de la puissance d'émission. L'amplificateur logarithmique 58 est par exemple disposé dans le module d'amplification 42 et fournit une tension de sortie $V_{OUT}$ proportionnelle à la portion $P_{RFIN}$ de puissance d'émission qu'il reçoit :

$$V_{OUT} = \lambda.\big[(P_{RFIN})_{dB} - (P_{INT})_{dB}\big],$$

où $P_{RFIN}$ représente l'atténuation en dB dans l'amplificateur logarithmique 58.

En pratique, il est simple de concevoir l'amplificateur logarithmique 58 avec une très bonne linéarité sur une plage de 50dB fournissant une tension de sortie sur une plage de 1 V. Cela conduit à une précision de sortie de 20mV/dB.

Puisque le générateur 12 de signaux radiofréquences est numérique, le circuit de calibration 54 comporte en outre un convertisseur analogique/numérique 60 disposé dans le générateur numérique 12. Grâce à ce convertisseur, la tension analogique $V_{OUT}$ fournie par l'amplificateur logarithmique 58 est convertie en grandeur numérique, par exemple sur 10 bits. Pour une précision de calibration requise de 0,1 dB, des variations de 2 mV sur cette tension analogique $V_{OUT}$ prenant ses valeurs sur une plage de 1 V doivent pouvoir être détectées. Cette exigence est effectivement satisfaite avec un convertisseur exprimant ses valeurs de sortie sur 10 bits (i.e. 1024 valeurs de sortie différentes possibles).

En termes de rapidité de traitement, une calibration est un traitement lent qui n'impose pas d'exigence particulière sur la vitesse de traitement du convertisseur 60.

Le circuit interne de calibration 54 fournit donc au générateur 12 de signaux radiofréquences une information sur la puissance, c'est-à-dire de façon équivalente sur l'amplitude, du signal radiofréquence émis. Grâce à cette seule information, il est possible de mettre en oeuvre une méthode simple de calibration visant à traiter les signaux issus du dispositif numérique de traitement 20 pour compenser les effets des différences entre les paramètres de gain et de phase des deux amplificateurs 44 et 46. Cette méthode de calibration peut être mise en oeuvre dans un module de calibration 62 du circuit interne 54, prévu en sortie du convertisseur 60 dans le générateur 12 de signaux radiofréquences.

On remarque que ce circuit interne de calibration 54 présente un premier avantage lié à sa simplicité de mise en oeuvre.

En outre, bien qu'il s'intègre avantageusement dans le système d'émission 10 précédemment décrit, on notera que son intérêt ne se limite pas à cette architecture. Il pourrait aussi bien être intégré dans un système d'émission dont le générateur de signaux radiofréquences est au moins partiellement analogique. Il pourrait notamment être intégré dans un système d'émission dans lequel la modulation est analogique. Mais il pourrait aussi être intégré dans un système d'émission dans lequel le module de production du signal porteur d'information et le dispositif de traitement sont analogiques : dans ce cas, il ne serait pas nécessaire qu'il comporte le convertisseur 60.

Ce second aspect de l'invention est aussi indépendant du premier aspect de l'invention. En effet, il pourrait également être avantageusement intégré dans un système d'émission dont le dispositif numérique de traitement ne fonctionne pas comme celui qui a été décrit précédemment. En particulier, il pourrait être avantageusement intégré dans une architecture LINC.

Par ailleurs, le circuit interne de calibration 54 présente un second avantage. Grâce à la seule information sur la puissance, ou l'amplitude, du signal radiofréquence émis, il est également possible de mettre en oeuvre, avec ce circuit, une méthode simple de prédistorsion visant à traiter les signaux issus du dispositif numérique de traitement 20 pour compenser la non linéarité des amplificateurs 38 et 40 dans le cas où ceux-ci ne sont pas utilisés uniquement en zone de saturation de gain. C'est par exemple le cas du système d'émission 10 précédemment décrit dans le cadre du fonctionnement du dispositif numérique de traitement 20 selon le premier aspect de l'invention : dans ce cas, une partie des signaux traités est transformée par les moyens 26 pour former des signaux à amplitudes identiques mais variables ce qui induit une utilisation des amplificateurs 38 et 40 en zone de gain variable. Ce pourrait être également le cas d'autres fonctionnements indépendants du premier aspect de l'invention. Un même circuit interne de conception très simple peut donc remplir les fonctions d'un circuit de calibration et d'un circuit de prédistorsion. Comme précédemment pour la calibration, la méthode de prédistorsion peut être mise en oeuvre dans le module de calibration 62 qui devient alors un module de calibration et de prédistorsion.

Au vu de ce qui précède, il apparaît clairement que le second aspect de l'invention, bien qu'avantageusement combiné au premier aspect, reste indépendant de ce dernier et comporte ses propres avantages techniques.

Comme indiqué précédemment, une méthode de calibration et deux méthodes de prédistorsion pouvant être mises en oeuvre dans le module 62 grâce à ce simple circuit interne de calibration et de prédistorsion 54 seront détaillées en référence aux figures 3A, 3B, 4A, 4B, 5A et 5B.

Un mode de réalisation du procédé de traitement mis en oeuvre dans le dispositif numérique de traitement 20 va tout d'abord être détaillé en référence aux figures 2A, 2B et 2C.

Lors d'une première étape E1 indiquée sur la figure 1, le signal numérique complexe porteur d'information $s_I(t)$ est fourni en entrée des moyens de comparaison 22. Au cours de cette étape, son amplitude variable $A_I(t)$ est comparée à une valeur prédéterminée $A_{MIN}$ constante, par exemple définie comme étant égale à la moitié de la valeur maximale $A_{MAX}$ qu'elle peut prendre.

Si, en sortie de ces moyens de comparaison 22, l'amplitude du signal porteur d'information est supérieure à cette valeur prédéterminée $A_{MIN}$, on passe à une étape E2 lors de laquelle le signal $s_I(t)$ est traité par les premiers moyens de transformation 24. On se trouve alors dans la configuration de la figure 2A.

Sur cette figure 2A, les signaux sont représentés vectoriellement dans le plan complexe en prenant le signal $s_I(t)$ comme repère pour définir l'axe des abscisses. Le signal $s_I(t)$ peut alors être défini comme la somme vectorielle de deux signaux $s^p(t)$ et $s^n(t)$ d'amplitudes identiques et constantes de valeur $A_{MIN}$, et dont les déphasages opposés $\varphi(t)$ et $-\varphi(t)$ par rapport à $s_I(t)$ sont variables en fonction des valeurs du signal porteur d'information : en particulier, dans l'exemple non limitatif illustré sur la figure 2A, $\varphi(t)$ varie entre 0 (pour $A_I(t) = A_{MAX}$) et $\varphi_{MAX} = 60°$ (pour $A_I(t) = A_{MIN} = A_{MAX}/2$).

Si, en sortie des moyens de comparaison 22, l'amplitude du signal porteur d'information est inférieure à la valeur prédéterminée $A_{MIN}$, on passe à une étape E3 lors de laquelle le signal $s_I(t)$ est traité par les seconds moyens de transformation 26. On peut alors se trouver, selon une première variante possible, dans la configuration de la figure 2B.

Sur cette figure 2B, le signal $s_I(t)$ peut être défini comme la somme vectorielle de deux signaux $s^p(t)$ et $s^n(t)$ de déphasages opposés et constants de valeurs respectives $\varphi_{MAX} = 60°$ et $-\varphi_{MAX} = -60°$, et dont les amplitudes identiques sont variables en fonction des valeurs du signal porteur d'information : en particulier, dans l'exemple non limitatif illustré sur la figure 2B, elles varient entre 0 (pour $A_I(t) = 0$) et $A_{MIN}$ (pour $A_I(t) = A_{MIN}$).

La saturation en phase qui se produit lorsque l'on passe de la configuration de la figure 2A (amplitude constante égale à $A_{MIN}$, phase variable entre 0 et $\varphi_{MAX}$) à celle de la figure 2B (amplitude variable entre 0 à $A_{MIN}$, phase constante égale à la valeur de saturation $\varphi_{MAX}$) peut engendrer ensuite, en sortie des modulateurs sigma delta, un élargissement du spectre des signaux modulés, ce qui est préjudiciable pour certaines applications à large bande.

Dans ce cas, une variante possible à la configuration 2B est celle qui est illustrée sur la figure 2C. Sur cette figure, le signal $s_i(t)$ est toujours défini comme la somme vectorielle de deux signaux $s^p(t)$ et $s^n(t)$ de déphasages opposés par rapport à $s_i(t)$, mais ces signaux décrivent des courbes C et C', selon lesquelles les déphasages $\varphi(t)$ et $-\varphi(t)$ tendent progressivement de $\varphi_{MAX} = 60°$ et $-\varphi_{MAX} = -60°$ vers de nouvelles valeurs maximales, $\varphi_{MAX'} = 70°$ et $-\varphi_{MAX'} = -70°$ par exemple, au fur et à mesure que leurs amplitudes identiques variables décroissent, ces nouvelles valeurs maximales n'étant atteintes que lorsque ces amplitudes atteignent 0, de manière à éviter toute saturation de la phase. Autrement dit, le long de ces courbes C et C', les deux signaux $s^p(t)$ et $s^n(t)$ sont de déphasages opposés, mais ces déphasages ainsi que leurs amplitudes identiques sont variables en fonction des valeurs du signal porteur d'information. Plus précisément, les courbes C et C' sont configurées de telle sorte que la phase subit une compression douce au lieu d'une saturation.

Un mode de réalisation d'une méthode de calibration pouvant être mise en oeuvre dans le système d'émission 10, en particulier grâce au circuit interne de calibration 54 et son module 62, va maintenant être détaillé en référence aux figures 3A et 3B.

Pour simplifier les calculs, supposons que les différences entre les paramètres $G_p$ et $\alpha_p$ de l'amplificateur 44, d'une part, et $G_n$ et $\alpha_n$ de l'amplificateur 46, d'autre part, induisent un décalage en gain $\Delta$ et en phase $\alpha$ du signal $s^p(t)$ par rapport au signal $s^n(t)$ et que ce dernier est d'amplitude unité. Supposons également que les dispositifs de filtrage du système d'émission sont idéaux et n'engendrent pas de décalages supplémentaires. Supposons enfin que les amplificateurs 44 et 46 sont utilisés en saturation de gain.

Lors d'une première étape de calibration, le générateur de signaux 12 produit deux signaux $s^p(t)$ et $s^n(t)$ en opposition de phase.

Après amplification, ces deux signaux deviennent, comme indiqué précédemment, $s_o^p(t)$ et $s_o^n(t)$.

Si le module d'amplification ne générait pas de décalage en gain et en phase, le signal radiofréquence résultant

$$s_o(t) = s_o^p(t) + s_o^n(t) \text{ devrait être nul.}$$

Mais puisqu'un décalage existe entre les deux amplificateurs, pour $s_o^n(t) = \exp(j.(\theta(t) + \pi))$, on a

$$s_o^p(t) = (1 + \Delta).(\cos(\alpha) + j\sin(-\alpha)).\exp(j.\theta(t)). \text{ D'où en sortie un signal radiofréquence dont l'amplitude n'est}$$

pas nulle :

$$\left| s_o(t) \right| = \sqrt{\left[\cos(\alpha).(1 + \Delta) - 1\right]^2 + \left[\sin(\alpha).(1 + \Delta)\right]^2} \,.$$

On se trouve alors dans la configuration de la figure 3A.

Lors d'une deuxième étape de calibration, l'amplitude du signal de sortie est mesurée et renvoyée au générateur de signaux 12 par le circuit interne de calibration 54.

En remarquant que l'amplitude mesurée $|s_o(t)|$ est une fonction monotone du décalage en gain $\Delta$ et en phase $\alpha$ des deux amplificateurs 44 et 46, il suffit d'appliquer une précorrection en gain et en phase à au moins l'un des deux signaux $s^p(t)$ et $s^n(t)$, au cours d'une troisième étape de calibration, puis de reproduire itérativement les trois étapes de calibration précitées selon par exemple une méthode d'optimisation telle qu'une descente de gradients, pour converger vers un minimum dont la valeur finale est significative de la qualité de la calibration.

En fin d'itération, par exemple lorsque l'on se trouve dans la configuration de la figure 3B, les valeurs de précorrection de gain et de phase aboutissant à cette configuration sont conservées en mémoire pour être appliquées ultérieurement lors de la génération et de la transmission de tout signal porteur d'une information destinée à être émise sous forme de signal radiofréquence par le système d'émission 10.

Grâce à cette méthode de calibration mise en oeuvre par le circuit interne de calibration 54, pouvant par ailleurs être exécutée à n'importe quel moment (hors émission de signaux) et en toute transparence, il apparaît clairement que même si les amplificateurs 44 et 46 présentent un décalage en gain et en phase et même si celui-ci est susceptible d'évoluer dans le temps, il peut être simplement corrigé avec efficacité.

Un premier mode de réalisation d'une méthode de prédistorsion pouvant être mise en oeuvre dans le système d'émission 10, en particulier grâce au circuit interne de calibration 54 et son module 62 qui remplissent également une fonction de prédistorsion, va maintenant être détaillé en référence aux figures 4A et 4B.

Comme cela a été vu précédemment lors de la description du premier aspect de l'invention, une prédistorsion des deux signaux d'amplitudes identiques et de déphasages opposés peut s'avérer nécessaire, ou au moins avantageuse, lorsque leurs amplitudes sont variables (configurations des figures 2B et 2C par exemple) et que les amplificateurs 44 et 46 ne fonctionnent pas toujours en saturation de gain.

Cela peut être mis en oeuvre grâce à l'exécution préalable d'une méthode de prédistorsion pour estimer des valeurs de coefficients de prédistorsion à appliquer aux gains et phases des deux signaux d'amplitudes identiques et de déphasages opposés.

Lors d'une première étape de prédistorsion, le générateur de signaux 12 produit deux signaux $s^p(t)$ et $s^n(t)$ en opposition de phase (par exemple de phases respectives 0 et $\pi$) et d'amplitudes égales. Par exemple, $s^p(t) = A$ et $s^n(t) = -A$. Lorsque les amplificateurs ne fonctionnent pas en saturation de gain, les paramètres $G_p$ et $\alpha_p$ de l'amplificateur 44, d'une part, et $G_n$ et $\alpha_n$ de l'amplificateur 46, d'autre part, sont fonction de la valeur de A selon les relations suivantes :

$$s_o^p(t) = G_p(A).\exp(j.\alpha_p(A)).A \,,$$

et

$$s_o^n(t) = -G_n(A).\exp(j.\alpha_n(A)).A \,.$$

Lors d'une deuxième étape de prédistorsion, un calcul de coefficients de prédistorsion portant sur le gain $G_p(A)$ de l'amplificateur 44 est exécuté.

Au cours de cette étape, on règle le signal $s^p(t)$ à un niveau tel que la puissance $P^p(-20dB)$ en sortie de l'amplificateur 44 soit à 20dB en dessous de sa puissance de saturation $P^pSAT$ :

$$P^p(-20dB) = P^p SAT - 20dB \,.$$

Par ailleurs, on règle le signal $s^n(t)$ à un niveau nul.

Puis on augmente la puissance du signal $s^p(t)$ de 1dB et on mesure la nouvelle puissance $P^p(-19dB)$ en sortie de l'amplificateur 44. On en déduit alors une constante de gain $G_p = P^p(-19dB) - P^p(-20dB)$.

Il est ensuite possible d'augmenter la puissance du signal $s^p(t)$ par pas de 1dB puis d'appliquer une prédistorsion d'amplitude associée à chaque niveau de puissance pour imposer un gain constant égal à la valeur initialement estimée de $G_p$. De la sorte, la progression de puissance en sortie de l'amplificateur 44 paraît linéaire.

Lors d'une troisième étape de prédistorsion, un calcul de coefficients de prédistorsion portant sur le gain $G_n(A)$ de l'amplificateur 46 est exécuté.

Au cours de cette étape, on règle le signal $s^n(t)$ à un niveau tel que la puissance $P^n(-20dB)$ en sortie de l'amplificateur 44 soit à 20dB en dessous de sa puissance de saturation $P^nSAT$ :

$$P^n(-20dB) = P^n SAT - 20dB \,.$$

Par ailleurs, on règle le signal $s^p(t)$ à un niveau nul.

Puis on augmente la puissance du signal $s^n(t)$ de 1dB et on mesure la nouvelle puissance $P^n(-19dB)$ en sortie de l'amplificateur 44. On en déduit alors une constante de gain $G_n = P^n(-19dB) - P^n(-20dB)$.

Il est ensuite possible d'augmenter la puissance du signal $s^n(t)$ par pas de 1dB puis d'appliquer une prédistorsion d'amplitude associée à chaque niveau de puissance pour imposer un gain constant égal à la valeur initialement estimée de $G_n$. De la sorte, la progression de puissance en sortie de l'amplificateur 46 paraît linéaire.

Lors d'une quatrième étape de prédistorsion, un calcul de coefficients de prédistorsion portant à la fois sur la phase $\alpha_p(A)$ de l'amplificateur 44 et sur la phase $\alpha_n(A)$ de l'amplificateur 46 est exécuté.

Au cours de cette étape, les amplitudes de $s^p(t)$ et $s^n(t)$ sont réglées à des valeurs $A_{p,-20dB}$ et $A_{n,-20dB}$, pour obtenir des puissances en sortie des amplificateurs à 20dB en dessous de leur puissance de saturation commune $P_{SAT}$ (après calibration).

La puissance de sortie mesurée par le circuit interne de calibration 54 est alors proportionnelle à $\left| s_o(t) \right|^2 = \left| s_o^p(t) + s_o^n(t) \right|^2$ , avec :

$$s_o^p(t) = G_p.\exp(j.\alpha_{p,-20dB}).A_{p,-20dB} \,,$$

et

$$s_o^n(t) = -G_n.\exp(j.\alpha_{n,-20dB}).A_{n,-20dB} \, .$$

A une puissance de 20dB en dessous de la puissance de saturation commune $P_{SAT}$, il est raisonnable de s'attendre à ce que $\alpha_{p,-20dB} \approx \alpha_n\text{,-}20dB \approx 0$.

En outre, grâce aux deuxième et troisième étapes de prédistorsion, il est possible de définir une amplitude de sortie commune $A_O = G_p.A_{p,-20dB} = G_n.A_{n,}\text{-}20dB$.

Par conséquent $s_o(t) = 0$ .

Ensuite, on augmente l'amplitude du premier signal $s^p(t)$ de sorte que la puissance en sortie du premier amplificateur 44 soit augmentée de 1dB tout en maintenant l'amplitude du second signal $s^n(t)$ à sa valeur $A_{n,-20dB}$. On se trouve alors dans la configuration de la figure 4A, dans laquelle une variation d'angle $\Delta\alpha_{p,-19dB}$ peut être calculée.

On obtient donc : $(G_p.A_{p,-19dB}) = F.(G_p.A_{p,-20dB}) = F.A_O$, avec F = 1,122 (i.e. 1dB).

Par suite :

$$s_o(t) = F.A_O.\exp(j.\Delta\alpha_{p,-19dB}) - A_O \, ,$$

$$\left|\frac{s_o(t)}{A_O}\right| = \left|F \cdot (\cos(\Delta\alpha_{p,-19dB}) + j.\sin(\Delta\alpha_{p,-19dB})) - 1\right| \, ,$$

$$\left|\frac{s_o(t)}{A_O}\right|^2 = 1 + F^2 - 2.F.\cos(j.\Delta\alpha_{p,-19dB}) \, ,$$

d'où

$$\left|\Delta\alpha_{p,-19dB}\right| = \arccos\left(\frac{1 + F^2 - |s_o(t)|^2 / |A_O|^2}{2.F}\right) .$$

En effet, seule la valeur absolue de la variation d'angle est retournée à cette étape puisque la fonction arccos ne retourne que des valeurs positives pour des petites valeurs d'angles.

Pour déterminer le signe de la variation d'angle $\Delta\alpha_{p,-19dB}$, on peut par exemple ajouter la valeur absolue précédemment retournée à la phase du signal $s^p(t)$.

On obtient alors : $s'_o(t) = F.A_O.exp(j.(\Delta\alpha_{p,-19dB} + |\Delta\alpha_{p,-19dB}|)) - A_O$.

Si $\Delta\alpha_{p,-19dB} + |\Delta\alpha_{p,-19dB}| = 0$, alors $\left|\dfrac{s'_o(t)}{A_O}\right|^2 = 1 + F^2 - 2.F$ et cette nouvelle valeur mesurée est inférieure à la précédente, ce qui prouve que $\Delta\alpha_{p,-19dB}$ est négative. On se trouve alors dans la configuration de la figure 4B.

Si $\Delta\alpha_{p,-19dB} + |\Delta\alpha_{p,-19dB}| = 2\Delta\alpha_{p,-19dB}$, alors : $\left|\dfrac{s'_o(t)}{A_O}\right|^2 = 1 + F^2 - 2.F.\cos(j.2\Delta\alpha_{p,-19dB})$ et cette nouvelle valeur mesurée est supérieure à la précédente, ce qui prouve que $\Delta\alpha_{p,-19dB}$ est positive. On se trouve alors dans la configuration de la figure 4C.

On en déduit donc la valeur de $\Delta\alpha_{p,-19dB}$.

En procédant de façon similaire, dans la configuration de la figure 4D, il est possible de déterminer aussi la valeur de $|\Delta\alpha_{n,-19dB}|$ :

$$s_o(t) = A_O - F.A_O.\exp(j.\Delta\alpha_{n,-19dB}) \, ,$$

$$\left|\frac{s_o(t)}{A_O}\right|^2 = 1 + F^2 - 2.F.\cos(j.\Delta\alpha_{n,-19dB}),$$

d'où

$$\left|\Delta\alpha_{n,-19dB}\right| = \arccos\left(\frac{1 + F^2 - \left|s_o(t)\right|^2 / \left|A_O\right|^2}{2.F}\right).$$

Pour déterminer le signe de la variation d'angle $\Delta\alpha_{p,-19dB}$, comme précédemment on ajoute la valeur absolue retournée ci-dessus à la phase du signal $s^n(t)$.

On obtient alors : $s'_o(t) = A_O - F.A_O.\exp(j.(\Delta\alpha_{n,-19dB} + |\Delta\alpha_{n,-19dB}|))$.

Si $\Delta\alpha_{n,-19dB} + \Delta\alpha_{n,-19dB} = 0$ alors $\left|\dfrac{s'_o(t)}{A_O}\right|^2 = 1 + F^2 - 2.F$ et cette nouvelle valeur mesurée est inférieure à la précédente, ce qui prouve que $\Delta\alpha_{n,-19dB}$ est négative. On se trouve alors dans la configuration de la figure 4E.

Si $\Delta\alpha_{n,-19dB} + |\Delta\alpha_{n,-19dB}| = 2\Delta\alpha_{n,-19dB}$, alors : $\left|\dfrac{s'_o(t)}{A_O}\right|^2 = 1 + F^2 - 2.F.\cos(j.2\Delta\alpha_{n,-19dB})$ et cette nou-

velle valeur mesurée est supérieure à la précédente, ce qui prouve que $\Delta\alpha_{n,-19dB}$ est positive. On se trouve alors dans la configuration de la figure 4F.

On en déduit donc la valeur de $\Delta\alpha_{n,-19dB}$.

Grâce à ces valeurs, il est possible de compenser les distorsions de phase introduites par les amplificateurs 44 et 46 à une puissance de -19dB en dessous de la puissance de saturation commune $P_{SAT}$. En outre, puisqu'il est aussi possible de compenser les distorsions de gains grâce aux deuxième et troisième étapes de prédistorsion, cela garantit la possibilité de retrouver à $P_{SAT}$-19dB des signaux de même amplitude et en opposition de phase, comme cela a été possible à -20dB, en apportant les corrections suivantes :

$$s^p(t) = A_{p,-19dB}.\exp(-j.\Delta\alpha_{p,-19dB}),$$

et

$$s^n(t) = A_{n,-19dB}.\exp(-j.\Delta\alpha_{n,-19dB}).$$

Par conséquent, on retrouve $s_o(t) = 0$ à -19dB.

En procédant comme précédemment, il est ainsi possible de déterminer les valeurs de $\Delta\alpha_{p,-18dB}$ et $\Delta\alpha_{n,-18dB}$, puis de proche en proche, les valeurs de $\Delta\alpha_{p,x}$ et $\Delta\alpha_{p,x}$ jusqu'à la saturation $P_{SAT}$.

On en déduit alors les valeurs de la distorsion AM/PM à chaque niveau de puissance par les relations suivantes :

$$\alpha_p(ydB) = \sum_{x=-19dB}^{x=-ydB} \Delta\alpha_{p,x} \text{ et } \alpha_n(ydB) = \sum_{x=-19dB}^{x=-ydB} \Delta\alpha_{n,x}.$$

Il apparaît clairement que cette première méthode de prédistorsion peut être mise en oeuvre par le circuit interne de calibration 54, puisque seules les informations de puissance (ou amplitude) de sortie sont utiles pour calculer les coefficients de prédistorsion à appliquer aux signaux produits par le générateur 12. Comme pour le calibrage, cette méthode peut par ailleurs être exécutée à n'importe quel moment (hors émission de signaux) et en toute transparence, de sorte que même si les amplificateurs 44 et 46 présentent des non linéarités en gain (AM/AM) et en phase (AM/PM) et même si celles-ci sont susceptibles d'évoluer dans le temps, elles peuvent être simplement corrigées avec efficacité.

Un second mode de réalisation d'une méthode de prédistorsion pouvant être mise en oeuvre dans le système d'émission 10, en particulier grâce au circuit interne de calibration 54 et son module 62, va maintenant être détaillé en référence aux figures 5A et 5B.

Dans ce second mode de réalisation, contrairement au premier, les calculs des coefficients de prédistorsion en amplitude et en phase sont réalisés simultanément. Chaque étape de cette méthode réalise une correction d'amplitude et de phase à chaque niveau de puissance.

Selon ce second mode de réalisation, le générateur de signaux 12 produit deux signaux $s^p(t)$ et $s^n(t)$ en quadrature de phase selon deux configurations appliquées successivement : à une première étape, l'angle entre les deux signaux $s^p(t)$ et $s^n(t)$ est de +90° (configuration de la figure 5A) ; à l'étape suivante, l'angle entre les deux signaux $s^p(t)$ et $s^n(t)$ est de -90° (configuration de la figure 5B).

Tout d'abord, les amplitudes de $s^p(t)$ et $s^n(t)$ sont réglées aux valeurs précitées $A_{p,-20dB}$ et $A_{n,-20dB}$, pour obtenir des puissances en sortie des amplificateurs à 20dB en dessous de leur puissance de saturation commune $P_{SAT}$. De même que dans la première méthode de prédistorsion, à cette puissance il est raisonnable de s'attendre à ce que $\alpha_{p,-20dB} \approx \alpha_{n,-20dB} \approx 0$.

Ensuite, on augmente l'amplitude du second signal $s^n(t)$ de 1dB et on mesure deux fois à l'aide du circuit interne de calibration 54 l'amplitude du signal de sortie : une fois dans chaque configuration 5A et 5B.

On obtient alors :

$$s_{o,a}(t) = G_{p,-20dB}.A_{p,-20dB} + G_{n,-19dB}.A_{n,-19dB}.\exp(j.(\frac{\pi}{2} + \Delta\alpha_{n,-19dB})) ,$$

et

$$s_{o,b}(t) = G_{p,-20dB}.A_{p,-20dB} + G_{n,-19dB}.A_{n,-19dB}.\exp(j.(-\frac{\pi}{2} + \Delta\alpha_{n,-19dB})) .$$

En supposant en plus que :

$$G_{p,-20dB}.A_{p,-20dB} = A_O ,$$

et

$$G_{n,-19dB}.A_{n,-19dB} = F_{n,-19dB} \cdot A_O ,$$

où $F_{n,-19dB}$ est une inconnue, on obtient un système de deux équations à deux inconnues :

$$\left|s_{o,a}(t)\right|^2 = A_O^2.\left(1 + 2.F_{n,-19dB}.\sin\Delta\alpha_{n,-19dB} + F_{n,-19dB}^2\right),$$

et

$$\left|s_{o,b}(t)\right|^2 = A_O^2.\left(1 - 2.F_{n,-19dB}.\sin\Delta\alpha_{n,-19dB} + F_{n,-19dB}^2\right).$$

Ce système donne le résultat suivant :

$$F_{n,-19dB} = \sqrt{\frac{\left|s_{o,a}\right|^2 + \left|s_{o,b}\right|^2}{2.A_O^2} - 1} ,$$

et

$$\Delta\alpha_{n,-19dB} = \arcsin\left(\frac{\left|s_{o,a}\right|^2 - \left|s_{o,b}\right|^2}{4.A_O^2.F_{n,-19dB}}\right).$$

On procède de façon similaire pour déterminer $F_{p,19db}$ et $\Delta\alpha_{p,-19dB}$.

Grâce à ces valeurs, il est possible de compenser les distorsions de gains et de phases introduites par les amplificateurs 44 et 46 à une puissance de -19dB en dessous de la puissance de saturation commune $P_{SAT}$. Cela garantit la possibilité de retrouver à $P_{SAT}$-19dB des signaux corrigés de la façon suivante :

$$s^p(t) = A_{p,-19dB}.\exp(-j.\Delta\alpha_{p,-19dB}),$$

et

$$s^n(t) = A_{n,-19dB}.\exp(-j.\Delta\alpha_{n,-19dB}).$$

En partant de ces signaux corrigés, il est alors possible de déterminer comme précédemment $F_{p,-18dB}$, $\Delta\alpha_{p,-18dB}$, $F_{n,-18dB}$ et $\Delta\alpha_{n,-18dB}$, puis de proche en proche $F_{p,x}$, $\Delta\alpha_{p,x}$, $F_{n,x}$ et $\Delta\alpha_{n,x}$ jusqu'à la saturation $P_{SAT}$.

On en déduit alors les valeurs des distorsions AM/AM et AM/PM à chaque niveau de puissance par les relations suivantes :

$$\alpha_p(ydB) = \sum_{x=-19dB}^{x=-ydB}\Delta\alpha_{p,x}, \qquad \alpha_n(ydB) = \sum_{x=-19dB}^{x=-ydB}\Delta\alpha_{n,x},$$

$$F_p(ydB) = \prod_{x=-19dB}^{x=-ydB}F_{p,x}, \qquad F_n(ydB) = \prod_{x=-19dB}^{x=-ydB}F_{n,x}.$$

Il apparaît clairement que cette seconde méthode de prédistorsion peut aussi être mise en oeuvre simplement grâce à la présence du circuit interne de calibration 54, qui remplit alors une fonction de circuit interne de prédistorsion, puisque seules les informations de puissance (ou amplitude) de sortie sont utiles pour calculer les coefficients de prédistorsion à appliquer aux signaux produits par le générateur 12.

On notera par ailleurs qu'un avantage de la seconde méthode de prédistorsion par rapport à la première est qu'elle nécessite une dynamique moins importante dans la mesure des valeurs de $|s_o(t)|$. En effet, pour réaliser cette prédistorsion, le générateur 12 produit des signaux en quadrature de phase de sorte que la somme des deux en sortie du module d'amplification est d'amplitude plus grande, donc de dynamique moins importante, que lorsque les signaux produits sont en opposition de phase. En outre, cette seconde méthode apparaît plus simple et plus puissante que la première.

Il apparaît clairement qu'un dispositif de traitement tel que celui décrit conformément à un mode de réalisation du premier aspect de l'invention est moins sensible à une calibration imparfaite en gain et en phase qu'un dispositif de traitement de type LINC.

En termes de consommation d'énergie, des économies peuvent être réalisées grâce à ce dispositif de traitement si des amplificateurs dont la consommation dépend du niveau d'amplitude des signaux amplifiés sont utilisés.

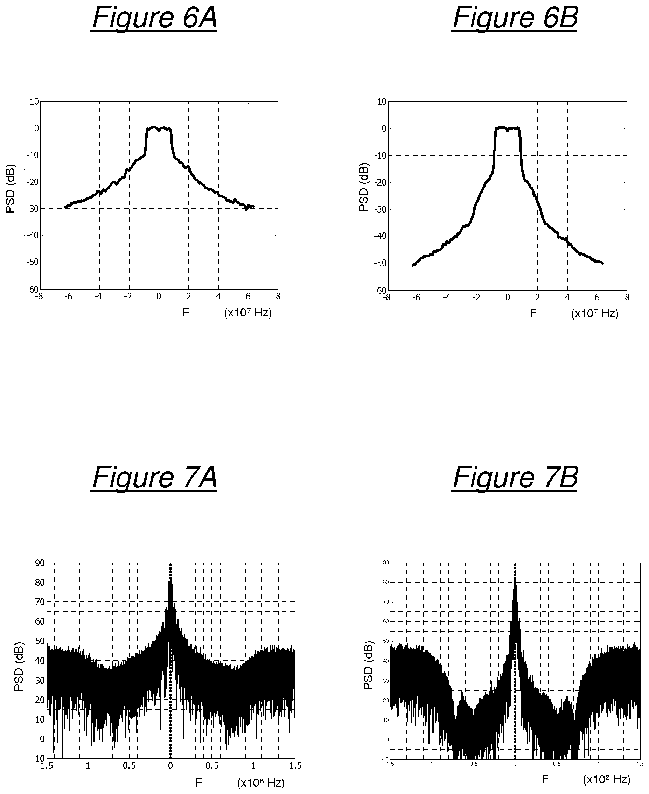

En termes de modulation spectrale, un autre avantage apparaît clairement au vu des figures 6A et 6B. Dans le générateur numérique 12 de signaux précédemment décrit, la transformation réalisée par le dispositif de traitement 20 est susceptible d'engendrer un élargissement du spectre des deux signaux obtenus par cette transformation du signal porteur d'information généré en bande de base.

Lorsqu'une transformation de type LINC est appliquée à un signal de type OFDM, le spectre (identique) des deux signaux obtenus après modulation sigma delta est très large, comme cela est visible sur la figure 6A. On voit sur cette figure qu'une largeur spectrale d'au moins 120 MHz est nécessaire pour inclure toute la densité spectrale de ces signaux. Or c'est nettement plus large que le signal OFDM en bande de base d'origine (environ 18 MHz) et même plus large que la bande passante des filtres analogiques pouvant être utilisés. On peut alors éventuellement envisager d'émettre sans trop de dommages dans le canal central de la bande de fréquences d'émission, mais dès que l'on s'en écarte, on risque de déformer le signal.

Lorsqu'une transformation selon le premier aspect de l'invention est appliquée à un signal de type OFDM, le spectre (identique) des deux signaux obtenus après modulation sigma delta est nettement moins large, comme cela est visible sur la figure 6B.

De même, lorsqu'une transformation de type LINC est appliquée à un signal de type WCDMA, le spectre (identique) des deux signaux obtenus après modulation sigma delta est très large, comme cela est visible sur la figure 7A. Il peut s'étaler sur 100 MHz. En revanche, lorsqu'une transformation selon le premier aspect de l'invention est appliquée à ce même signal de type WCDMA, le spectre (identique) des deux signaux obtenus après modulation sigma delta est beaucoup moins large, comme cela est visible sur la figure 7B. Il s'étale alors sur seulement 25 MHz.

Il est vrai qu'un dispositif de traitement et qu'un système d'émission selon l'invention sollicitent les amplificateurs qu'ils utilisent à des gains inférieurs à leur gain de saturation. Ils deviennent alors plus sensibles aux non linéarités de ces amplificateurs. Mais il a été vu que des méthodes de prédistorsion peuvent être mises en oeuvre grâce à la présence d'un simple circuit interne de calibration qui peut alors remplir également une fonction de prédistorsion sans nécessiter d'aménagement particulier.

Enfin, on notera que l'invention n'est pas limitée aux modes de réalisation précédemment décrits et aux normes d'émission radiofréquences citées. La transformation proposée, notamment selon les configurations illustrées par les figures 2B et 2C mais pas uniquement, peut être adaptée à d'autres normes de modulation non citées, de manière à trouver le meilleur compromis entre la largeur de bande de la modulation, l'efficacité en termes de puissance fournie par rapport à la consommation d'énergie et la linéarité de transmission.

**Revendications**

1. Dispositif (20) de traitement d'un signal porteur d'une information destinée à être transmise à l'aide d'un signal radiofréquence, pour la transformation de ce signal en deux signaux d'amplitudes identiques déphasés respectivement par rapport au signal porteur de l'information selon deux déphasages variables et opposés, **caractérisé en ce qu'**il comporte des moyens (22, 24, 26) de transformation du signal porteur d'information conçus pour :

   - transformer le signal porteur d'information en deux signaux d'amplitudes constantes et de déphasages variables en fonction des valeurs du signal porteur d'information, tant que l'amplitude du signal porteur d'information est supérieure à une valeur prédéterminée, et
   - transformer le signal porteur d'information en deux signaux d'amplitudes variables en fonction des valeurs du signal porteur d'information, lorsque l'amplitude du signal porteur d'information est inférieure à cette valeur prédéterminée.

2. Dispositif de traitement (20) selon la revendication 1, dans lequel les moyens de transformation (22, 24, 26) sont conçus pour transformer le signal porteur d'information en deux signaux de phases constantes fixées en valeur absolue à une valeur maximale et d'amplitudes variables en fonction des valeurs du signal porteur d'information, lorsque que l'amplitude du signal porteur d'information est inférieure à la valeur prédéterminée.

3. Dispositif de traitement (20) selon la revendication 1 ou 2, dans lequel la valeur prédéterminée est définie en fonction d'une distribution de l'amplitude du signal porteur d'information.

4. Système (10) d'émission de signaux radiofréquence comportant :

   - des moyens (18) de production d'un signal complexe porteur d'information à moduler,
   - un dispositif de traitement (20) selon l'une quelconque des revendications 1 à 3, pour la transformation de ce signal complexe en deux signaux d'amplitudes identiques,
   - des moyens ($28_I$, $28_Q$, $30_I$, $30_Q$) de modulation des deux signaux d'amplitudes identiques comportant deux voies de modulation distinctes,
   - des moyens (50) de recombinaison des deux signaux d'amplitudes identiques modulés pour la formation d'un signal radiofréquence à émettre, et
   - des moyens (16) d'émission de ce signal radiofréquence.

5. Système (10) d'émission de signaux radiofréquences selon la revendication 4, dans lequel les moyens de production (18), le dispositif de traitement (20) et les moyens de modulation ($28_I$, $28_Q$, $30_I$, $30_Q$) sont numériques, chaque voie de modulation comportant au moins un modulateur numérique de type sigma delta.

6. Système (10) d'émission de signaux radiofréquences selon la revendication 5, dans lequel les moyens de recombinaison (50) sont analogiques, le système comportant en outre :

   - des moyens (34, 36) de conversion numérique/analogique des deux signaux d'amplitudes identiques issus des moyens de modulation ($28_I$, $28_Q$, $30_I$, $30_Q$), pour la fourniture de deux signaux analogiques,
   - des moyens (38, 40) de filtrage passe bande des deux signaux analogiques dans une bande de fréquence d'émission prédéterminée, et
   - des moyens (42) d'amplification des deux signaux analogiques filtrés pour la fourniture de deux signaux analogiques filtrés et amplifiés aux moyens de recombinaison (50).

7. Système (10) d'émission de signaux radiofréquences selon la revendication 6, comportant en outre un circuit interne de calibration (54) conçu pour compenser un décalage en gain et en phase des moyens (42) d'amplification des deux signaux analogiques filtrés.

8. Système (10) d'émission de signaux radiofréquences selon la revendication 6 ou 7, comportant en outre un circuit interne de prédistorsion (54) conçu pour compenser une non linéarité en gain et/ou en phase des moyens (42) d'amplification des deux signaux analogiques filtrés.

9. Système (10) d'émission de signaux radiofréquences selon les revendications 7 et 8, dans lequel le circuit interne de calibration et le circuit interne de prédistorsion sont formés par un même circuit (54) comportant un dispositif de couplage (56) positionné dans les moyens de recombinaison (50) pour récupérer une portion de la puissance d'émission du signal radiofréquence et un amplificateur logarithmique (58) pour transformer cette portion récupérée en une tension exploitable par le dispositif de traitement (20).

10. Procédé de traitement d'un signal porteur d'une information destinée à être transmise à l'aide d'un signal radiofréquence, pour la transformation de ce signal en deux signaux d'amplitudes identiques déphasés respectivement par rapport au signal porteur de l'information selon deux déphasages variables et opposés, **caractérisé en ce qu'**il comporte les étapes suivantes :

    - transformer (E2) le signal porteur d'information en deux signaux d'amplitudes constantes et de déphasages variables en fonction des valeurs du signal porteur d'information, tant que l'amplitude du signal porteur d'information est supérieure à une valeur prédéterminée, et
    - transformer (E3) le signal porteur d'information en deux signaux d'amplitudes variables en fonction des valeurs du signal porteur d'information, lorsque l'amplitude du signal porteur d'information est inférieure à cette valeur prédéterminée.


**Patentansprüche**

1. Vorrichtung (20) zum Verarbeiten eines Trägersignals einer Information, die mithilfe eines Hochfrequenzsignals übertragen werden soll, zum Umwandeln dieses Signals in zwei Signale mit identischen Amplituden, die jeweils auf das Trägersignal der Information bezogen um zwei veränderliche und entgegengesetzte Phasenverschiebungen phasenverschoben sind, **dadurch gekennzeichnet, dass** sie Mittel (22, 24, 26) zum Umwandeln des Informationsträgersignals umfasst, die dazu ausgebildet sind:

   - das Informationsträgersignal in zwei Signale mit konstanten Amplituden und abhängig von den Werten des Informationsträgersignals veränderlichen Phasenverschiebungen umzuwandeln, sofern die Amplitude des Informationsträgersignals über einem vorbestimmten Wert liegt, und
   - das Informationsträgersignal in zwei Signale mit abhängig von den Werten des Informationsträgersignals veränderlichen Amplituden umzuwandeln, wenn die Amplitude des Informationsträgersignals unter diesem vorbestimmten Wert liegt.

2. Verarbeitungsvorrichtung (20) nach Anspruch 1, wobei die Umwandlungsmittel (22, 24, 26) dazu ausgebildet sind, das Informationsträgersignal in zwei Signale mit konstanten Phasen, die im Absolutwert auf einen maximalen Wert festgelegt sind, und mit abhängig von den Werten des Informationsträgersignals veränderlichen Amplituden umzuwandeln, wenn die Amplitude des Informationsträgersignals unter dem vorbestimmten Wert liegt.

3. Verarbeitungsvorrichtung (20) nach Anspruch 1 oder 2, wobei der vorbestimmte Wert abhängig von einer Verteilung der Amplitude des Informationsträgersignals definiert wird.

4. System (10) zum Senden von Hochfrequenzsignalen, umfassend:

   - Mittel (18) zum Produzieren eines komplexen Informationsträgersignals, das moduliert werden soll,
   - eine Verarbeitungsvorrichtung (20) nach einem der Ansprüche 1 bis 3, zum Umwandeln dieses komplexen Signals in zwei Signale mit identischen Amplituden,
   - Mittel ($28_I$, $28_Q$, $30_I$, $30_Q$) zum Modulieren der zwei Signale mit identischen Amplituden, die zwei verschiedene Modulationswege umfassen,
   - Mittel (50) zum Rekombinieren der zwei modulierten Signale mit identischen Amplituden, zum Bilden eines Hochfrequenzsignals, das gesendet werden soll, und
   - Mittel (16) zum Senden dieses Hochfrequenzsignals.

5. System (10) zum Senden von Hochfrequenzsignalen nach Anspruch 4, wobei die Produktionsmittel (18), die Verarbeitungsvorrichtung (20) und die Moduliermittel ($28_I$, $28_Q$, $30_I$, $30_Q$) digital sind, wobei jeder Modulationsweg mindestens einen Digitalmodulator vom Sigma-Delta-Typ umfasst.

6. System (10) zum Senden von Hochfrequenzsignalen nach Anspruch 5, wobei die Rekombiniermittel (50) analog sind, wobei das System weiter umfasst:

   - Mittel (34, 36) zur Digital-Analog-Umwandlung der zwei aus den Moduliermitteln ($28_I$, $28_Q$, $30_I$, $30_Q$) stammenden Signale mit identischen Amplituden, zum Liefern von zwei analogen Signalen,
   - Mittel (38, 40) zur Bandpassfilterung der zwei analogen Signale in einem vorbestimmten Sendefrequenzband, und
   - Mittel (42) zum Verstärken der zwei gefilterten analogen Signale, zum Liefern von zwei gefilterten und verstärkten analogen Signalen an die Rekombiniermittel (50).

7. System (10) zum Senden von Hochfrequenzsignalen nach Anspruch 6, weiter eine interne Kalibrierschaltung (54) umfassend, die dazu ausgebildet ist, einen Verstärkungs- und Phasenversatz der Mittel (42) zum Verstärken der zwei gefilterten analogen Signale zu kompensieren.

8. System (10) zum Senden von Hochfrequenzsignalen nach Anspruch 6 oder 7, weiter eine interne Vorverzerrungsschaltung (54) umfassend, die dazu ausgebildet ist, eine Verstärkungs- und/oder Phasen-Nichtlinearität der Mittel (42) zum Verstärken der zwei gefilterten analogen Signale zu kompensieren.

9. System (10) zum Senden von Hochfrequenzsignalen nach den Ansprüchen 7 und 8, wobei die interne Kalibrierschaltung und die interne Vorverzerrungsschaltung von ein und derselben Schaltung (54) gebildet werden, die eine in den Rekombiniermitteln (50) positionierte Kopplungsvorrichtung (56) umfasst, um einen Teil der Sendeleistung des Hochfrequenzsignals zurückzugewinnen, und einen logarithmischen Verstärker (58), um diesen zurückgewonnenen Teil in eine Spannung umzuwandeln, die von der Verarbeitungsvorrichtung (20) genutzt werden kann.

10. Verfahren zum Verarbeiten eines Trägersignals einer Information, die mithilfe eines Hochfrequenzsignals übertragen werden soll, zum Umwandeln dieses Signals in zwei Signale mit identischen Amplituden, die jeweils auf das Trägersignal der Information bezogen um zwei veränderliche und entgegengesetzte Phasenverschiebungen phasenverschoben sind, **dadurch gekennzeichnet, dass** es die folgenden Schritte umfasst:

    - Umwandeln (E2) des Informationsträgersignals in zwei Signale mit konstanten Amplituden und abhängig von den Werten des Informationsträgersignals veränderlichen Phasenverschiebungen, sofern die Amplitude des Informationsträgersignals über einem vorbestimmten Wert liegt, und
    - Umwandeln (E3) des Informationsträgersignals in zwei Signale mit abhängig von den Werten des Informationsträgersignals veränderlichen Amplituden, wenn die Amplitude des Informationsträgersignals unter diesem vorbestimmten Wert liegt.

**Claims**

1. A device (20) for processing a signal carrying information intended to be transmitted using a radiofrequency signal, for the transformation of this signal into two signals of identical amplitude phase-shifted respectively relative to the information-carrying signal according to two variable and opposing phase shifts, **characterised in that** it includes means (22, 24, 26) for transforming the information-carrying signal designed to:

- transform the information-carrying signal into two signals of constant amplitude and of variable phase shifts according to the values of the information-carrying signal, for as long as the amplitude of the information-carrying signal is greater than a predetermined value, and
- transform the information-carrying signal into two signals of variable amplitude according to the values of the information-carrying signal, when the amplitude of the information-carrying signal is less than this predetermined value.

2. A processing device (20) according to claim 1, wherein the means of transformation (22, 24, 26) are designed to transform the information-carrying signal into two signals of constant phases which are set in absolute value terms at a maximum value, and of amplitudes which vary according to the values of the information-carrying signal, when the amplitude of the information-carrying signal is less than the predetermined value.

3. A processing device (20) according to claim 1 or 2, wherein the predetermined value is defined according to a distribution of the amplitude of the information-carrying signal.

4. A system (10) for transmission of radiofrequency signals including:

- means (18) of production of an information-carrying complex signal to be modulated,
- a processing device (20) according to any of the claims 1 to 3, for the transformation of this complex signal into two signals of identical amplitude,
- means ($28_I$, $28_Q$, $30_I$, $30_Q$) for modulating the two identical-amplitude signals including two separate modulation channels,
- means (50) for recombining the two modulated signals of identical amplitude for the formation of a radiofrequency signal to be transmitted, and
- means (16) of transmission of this radiofrequency signal.

5. A system (10) for transmitting radiofrequency signals according to claim 4, wherein the means of production (18), the processing device (20) and the means of modulation ($28_I$, $28_Q$, $30_I$, $30_Q$) are digital, and wherein each modulation channel has at least one digital modulator of the sigma-delta type.

6. A system (10) for transmission of radiofrequency signals according to claim 5, wherein the means of recombination (50) are analog, and wherein the system further includes:

- means (34, 36) of digital/analog conversion of both the identical-amplitude signals originating from the means of modulation ($28_I$, $28_Q$, $30_I$, $30_Q$), for the supply of two analog signals,
- means (38, 40) of band-pass filtering of the two analog signals in a predetermined transmission frequency band, and
- means (42) of amplification of the two filtered analog signals for the supply of two filtered and amplified analog signals to the means of recombination (50).

7. A system (10) for transmission of radiofrequency signals according to claim 6, further including an internal calibration circuit (54) designed to compensate for a gain and phase shift of the means (42) of amplification of both filtered analog signals.

8. A system (10) for transmission of radiofrequency signals according to claim 6 or 7, further including an internal predistortion circuit (54) designed to compensate for a gain and/or phase non-linearity of the means (42) of amplification of both filtered analog signals.

9. A system (10) for transmission of radiofrequency signals according to claims 7 and 8, wherein the internal calibration circuit and the internal predistortion circuit are formed by a single circuit (54) including a coupling device (56) forming part of the means of recombination (50) to recover a portion of the radiofrequency signal transmission power, and a logarithmic amplifier (58) to transform this recovered portion into a voltage which can be used by the processing device (20).

10. A method for processing a signal carrying information intended to be transmitted using a radiofrequency signal, for the transformation of this signal into two signals of identical amplitude phase-shifted respectively relative to the information-carrying signal according to two variable and opposing phase shifts, **characterised in that** it includes the following steps:

- transform (E2) the information-carrying signal into two signals of constant amplitude and of variable phase shifts according to the values of the information-carrying signal, for as long as the amplitude of the information-carrying signal is greater than a predetermined value, and
- transform (E3) the information-carrying signal into two signals of variable amplitude according to the values of the information-carrying signal, when the amplitude of the information-carrying signal is less than this predetermined value.

# Figure 1

## Figure 2A

$\varphi_{MAX} = 60°$

$A_{MIN} = A_{MAX}/2$

$s^p(t)$

$s^n(t)$

$s_l(t)$

## Figure 2B

$\varphi_{MAX} = 60°$

$A_{MIN} = A_{MAX}/2$

$s^p(t)$

$s^n(t)$

$s_l(t)$

## Figure 2C

$\varphi_{MAX'} = 70°$  $\varphi_{MAX} = 60°$

$A_{MIN} = A_{MAX}/2$

$s^p(t)$

$C$

$s^n(t)$

$s_l(t)$

$C'$

# Figure 3A

$s_o^n(t)$

$s_o(t)$

$s_o^p(t)$

# Figure 3B

$s_o^n(t)$

$s_o(t) \approx 0$

$s_o^p(t)$

# Figure 4A

$s_o(t)$

$s_o^p(t)$

$s_o^n(t)$

$\Delta\alpha_p$

# Figure 4B

$s_o^n(t)$

$s'_o(t)$

$s'_o^p(t)$

# Figure 4C

$s'_o(t)$

$s'_o^p(t)$

$s_o^n(t)$

$2\Delta\alpha_p$

## Figure 4D

## Figure 4E

## Figure 4F

## Figure 5A

## Figure 5B

## Figure 6A

## Figure 6B

## Figure 7A

## Figure 7B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **P. WURM ; A. SHIRAKAWA.** Radio transmitter architecture with all-digital modulator for opportunistic radio and modern wireless terminals. *CogART 2008, Proceedings on 2008 First International Workshop on Cognitive Radio and Advanced Spectrum Management,* 14 Février 2008

- **HELAOUI et al.** A New Mode-Multiplexing LINC Architecture to Boost the Efficiency of WiMAX Up-Link Transmitters. *IEEE Transactions on Microwave Theory,* 2007, vol. 55 (2
- **DE P.M. AZIZ ; H.V. SORENSEN ; J. VAN DER SPIEGEL.** An overview of sigma delta converters. *IEEE Signal Processing Magazine,* Janvier 1996, vol. 13 (1